# EUROPEAN PATENT APPLICATION

(11) **EP 4 814 510 A1**
(43) Date of publication of application: **30.09.2026**
(21) Application number: 26167170.5
(22) Date of filing: 24.03.2026
(51) Int. Cl.: G01R 31/385, G01R 31/367

(54) **BATTERY DIAGNOSTIC DEVICE AND METHOD THEREOF**

(30) Priority: 26.03.2025 KR 20250038981
(71) Applicant: SAMSUNG SDI CO., LTD., Yongin-si, Gyeonggi-do 17084 (KR)
(72) Inventor: KIM, Minsoo, 17084 Yongin-si (KR); HA, Jinsu, 17084 Yongin-si (KR); KWON, Moonseok, 17084 Yongin-si (KR); KA, Bokhyun, 17084 Yongin-si (KR)
(74) Representative: Marks & Clerk LLP

(57) **Abstract**

A battery diagnostic device and method are disclosed. The device includes: a measuring device to measure status values of a formed battery; a charge and discharge device to charge and discharge the battery over a plurality of cycles; and a control device to detect a discharge capacity in each cycle based on the status values measured in each cycle, detect an initial capacity increase amount of the battery based on a difference in discharge capacity between two cycles, detect a negative electrode undischarged capacity of the battery based on the discharge capacity in at least one cycle, and diagnose a formation status of the battery based on the initial capacity increase amount and the negative electrode undischarged capacity. Based on the diagnosis result, the control device is configured to invoke a second formation of the formed battery.

## Description

### BACKGROUND

### 1. Field

The present disclosure relates to a battery diagnostic device and a method for diagnosing the formation status of a battery.

### 2. Description of the Related Art

In general, a primary battery is not rechargeable, but a rechargeable (e.g., secondary) battery can be charged and discharged. Low-capacity rechargeable batteries may be used in portable small-sized electronic devices such as smartphones, feature phones, notebook computers, digital cameras, camcorders, and the like, and high-capacity rechargeable batteries may be used as a power source and a power storage device for driving a motor for a hybrid vehicle and an electric vehicle. The rechargeable battery includes an electrode assembly having a positive electrode and a negative electrode, a case accommodating the electrode assembly, and an electrode terminal connected to the electrode assembly.

The rechargeable battery undergoes a "formation" process after the electrode assembly is enclosed in a case with an electrolyte and assembled.

The formation process may include a step to stably activate the battery (e.g., form a strong film, impregnate, etc.) while charging and discharging the battery at low current. The rechargeable battery may change in its long-term life characteristics during the formation process. In this regard, the battery may lose capacity faster or fail early if the formation process is not performed properly.

The above information disclosed in this Background section is only for enhancement of understanding of the background of the described technology, and therefore it may contain information that does not form the prior art that would already be known in this country to a person of ordinary skill in the art.

### SUMMARY

The present disclosure is directed to a battery diagnostic device and a method for diagnosing the formation status of a battery (e.g., a battery in which the formation process has been completed).

Technical solutions obtainable from the present disclosure are not limited to the above-mentioned technical solutions. Further, other unmentioned technical solutions would be clearly understood from the following description by those having ordinary skill in the technical field to which the present disclosure pertains.

One aspect of the present disclosure to solve the above-mentioned technical object relates to a battery diagnostic device. The battery diagnostic device according to an embodiment includes: a measuring device configured to measure status values of a formed battery (e.g., a battery that has completed formation); a charge and discharge device configured to charge and discharge the formed battery over a plurality of cycles; and a control device configured to detect a discharge capacity in each cycle of the plurality of cycles based on the status values measured in each cycle, detect an initial capacity increase amount of the formed battery using a difference in discharge capacity between two cycles among the plurality of cycles, detect a negative electrode undischarged capacity of the formed battery based on the discharge capacity in at least one cycle among the plurality of cycles, and diagnose a formation status of the formed battery based on the initial capacity increase amount and the negative electrode undischarged capacity and output a diagnosis result, wherein, based on the diagnosis result, the control device is configured to invoke a second formation of the formed battery.

The charge and discharge rate (C-rate) in the two cycles may be 0.3C or more.

The control device may be further configured to detect the discharge capacity of the formed battery and the negative electrode capacity of the formed battery in a first cycle using the status values measured during the first cycle among the plurality of cycles, and determine the negative electrode undischarged capacity from the difference between the discharge capacity of the formed battery and the negative electrode capacity in the first cycle. The control device may be further configured to generate a differential voltage profile corresponding to the first cycle using the status values measured during the first cycle, and detect the negative electrode capacity using the differential voltage profile. The charge rate in a charge section of the first cycle may be 0.1C or less, and the discharge rate in a discharge section of the first cycle may be 0.3C or more.

The control device may be further configured to detect the discharge capacity of the formed battery in the first cycle and a second cycle among the plurality of cycles based on the status values, and may be further configured to detect the negative electrode undischarged capacity using the difference in discharge capacity between the first cycle and the second cycle.

The charge and discharge rate (C-rate) in the first cycle may be 0.1C or less, and the charge and discharge rate (C-rate) in the second cycle may be 0.3C or higher.

The battery diagnostic device may further include a storage device configured to store reference data. The control device may be further configured to diagnose the formation status of the formed battery by comparing the initial capacity increase amount and the negative electrode undischarged capacity with the reference data. The reference data may represent a correlation between a second initial capacity increase amount of a second battery and a second negative electrode undischarged capacity.

The control device may be further configured to detect the second initial capacity increase amount and the second negative electrode undischarged capacity from a plurality of batteries, and generate the reference data using the second initial capacity increase amount of the plurality of batteries and the second negative electrode undischarged capacity.

The control device may be further configured to determine a reference negative electrode undischarged capacity corresponding to the initial capacity increase amount of the formed battery using the reference data, and diagnose the formation status of the formed battery by comparing the negative electrode undischarged capacity of the formed battery with the reference negative electrode undischarged capacity.

The control device may be further configured to determine a reference initial capacity increase amount corresponding to the negative electrode undischarged capacity of the formed battery using the reference data, and may diagnose the formation status of the formed battery by comparing the initial capacity increase amount of the formed battery with the reference initial capacity increase amount.

An aspect of the present disclosure relates to a battery diagnostic method of at least one processor. The battery diagnostic method according to an embodiment includes charging and discharging the formed battery that has completed formation over a plurality of cycles, detecting a discharge capacity of the formed battery in each cycle based on status values of the formed battery measured in each cycle of the plurality of cycles, detecting an initial capacity increase amount of the formed battery using a difference in discharge capacity between two cycles among the plurality of cycles, detecting a negative electrode undischarged capacity of the formed battery based on the discharge capacity in at least one cycle among the plurality of cycles, diagnosing a formation status of the formed battery based on the initial capacity increase amount and the negative electrode undischarged capacity and outputting a diagnosis result, and performing a second formation of the formed battery based on the diagnosis result.

In the detecting of the initial capacity increase amount, the charge and discharge rate (C-rate) in the two cycles may be 0.3C or more.

The detecting of the negative electrode undischarged capacity may include determining the negative electrode undischarged capacity from the difference between the discharge capacity of the formed battery in a first cycle among the plurality of cycles and a negative electrode capacity of the formed battery. The detecting of the negative electrode undischarged capacity may further include generating a differential voltage profile corresponding to the first cycle using the status values measured during the first cycle, detecting a plurality of negative electrode-induced peaks in the differential voltage profile, and determining the negative electrode capacity based on the positions of the plurality of negative electrode-induced peaks. The charge rate in a charge section of the first cycle may be 0.1C or less, and the discharge rate in a discharge section of the first cycle may be 0.3C or more.

The detecting of the negative electrode undischarged capacity may further include determining the negative electrode undischarged capacity based on a difference in discharge capacity between a first cycle and a second cycle among the plurality of cycles,

The charge and discharge rate (C-rate) in the first cycle may be 0.1C or less, and the charge and discharge rate (C-rate) in the second cycle may be 0.3C or higher.

The diagnosing may include diagnosing the formation status of the formed battery by comparing the initial capacity increase amount and the negative electrode undischarged capacity with reference data. The reference data may represent the correlation between a second initial capacity increase amount of a second (e.g., normal) battery and a second negative electrode undischarged capacity.

The battery diagnostic method may further include detecting the second initial capacity increase amount and the second negative electrode undischarged capacity from a plurality of batteries, and generating the reference data using the second initial capacity increase amount of the plurality of batteries and the second negative electrode undischarged capacity.

The diagnosing of the formation status of the formed battery by comparing the initial capacity increase amount and the negative electrode undischarged capacity with the reference data may include determining a reference negative electrode undischarged capacity corresponding to the initial capacity increase amount of the formed battery using the reference data, and diagnosing the formation status of the formed battery by comparing the negative electrode undischarged capacity of the formed battery with the reference negative electrode undischarged capacity.

The diagnosing of the formation status of the formed battery by comparing the initial capacity increase amount and the negative electrode undischarged capacity with the reference data comprises determining a reference initial capacity increase amount corresponding to the negative electrode undischarged capacity of the formed battery using the reference data, and diagnosing the formation status of the formed battery by comparing the initial capacity increase amount of the formed battery with the reference initial capacity increase amount.

According to the present disclosure, it is possible to diagnose the formation status of a formed battery that has completed formation in real time.

Effects that may be obtained from the present disclosure are not limited to only the above described effects. In addition, other effects which are not described herein would be apparent to those skilled in the art from the following description.

At least some of the above and other features of the invention are set out in the claims.

### BRIEF DESCRIPTION OF THE DRAWINGS

The accompanying drawings illustrate one or more embodiments of the present disclosure and, together with the foregoing disclosure, serve to enhance understanding of the technical scope of the present disclosure. However, the present disclosure is not to be construed as being limited to the drawings.
FIG. 1 depicts a block diagram of a battery diagnostic device according to an embodiment of the present disclosure.
FIG. 2 depicts graphs of a positive electrode voltage profile, negative electrode voltage profile, and battery voltage profile, and a reversible capacity change of a battery during the initial charge and discharge period according to an embodiment of the present disclosure.
FIG. 3 depicts a graph of a relationship between an initial capacity increase amount of batteries and a negative electrode undischarged capacity as represented via a linear equation according to an embodiment of the present disclosure.
FIG. 4 depicts a graph of a trend line corresponding to reference data according to an embodiment of the present disclosure.
FIG. 5 depicts another block diagram of a battery diagnostic device according to an embodiment of the present disclosure.
FIG. 6 depicts another block diagram of a battery diagnostic device according to an embodiment of the present disclosure.
FIG. 7 depicts a graph of a differential voltage profile according to an embodiment of the present disclosure.
FIG. 8 depicts a flow diagram of a battery diagnostic method according to an embodiment of the present disclosure.
FIG. 9 depicts another flow diagram of a battery diagnostic method according to an embodiment of the present disclosure.

### DETAILED DESCRIPTION

Hereinafter, one or more embodiments of the present disclosure will be described in detail with reference to the accompanying drawings. Prior to making the description, the terms or words used in the specification and claims of the present invention should not be interpreted using typical or dictionary limited meanings, but are constructed as meanings and concepts conforming to the technical concepts of the present invention based on the principle that the inventors can appropriately define the concepts of the terms to explain the present invention in the best manner. Accordingly, it is to be understood that the detailed description, which will be disclosed along with the accompanying drawings, is intended to describe the embodiments of the present invention and is not intended to represent all technical ideas of the present invention. Therefore, it should be understood that various equivalents and modifications can exist which can replace the embodiments described at the time of filing the application. It should be further understood that the terms "comprise," "include" and/or "comprising" or "including," when used in this specification, specify the presence of stated features, numbers, steps, operations, elements, and/or components, but do not preclude the presence or addition of one or more other features, numbers, steps, operations, elements, components, and/or groups thereof. In addition, when describing embodiments of the present disclosure, "may" and "may be" may include "one or more embodiments of the present disclosure."

In addition, for ease of understanding of the present disclosure, the accompanying drawings are not drawn to real scale, but the dimensions of some components may be exaggerated. In addition, the same reference numbers may be assigned to the same components in different embodiments.

Stating that two objects of comparison are "the same" means that they are "substantially the same."

Therefore, "substantially identical" may include a deviation that is considered low in the art-for example, a deviation of less than 5%. In some embodiments, uniformity of a parameter in a certain region may mean uniformity from an average perspective.

Although terms such as "first," "second", and the like are used to explain various constituent elements, the constituent elements are not limited to such terms. These terms are only used to distinguish one constituent element from another constituent element. Unless explicitly stated to the contrary, the second constituent element may be referred to as the first constituent element.

Throughout the specification, unless otherwise stated, each component may be singular or plural.

It should also be understood that when a first element or layer is referred to as being present "on" or "beneath" a second element or layer, the first element may be disposed directly on or beneath the second element or may be disposed indirectly on or beneath the second element with a third element or layer being disposed between the first and second elements or layers.

It should be noted that if it is described in the specification that one component is "connected," "coupled," or "joined" to another component, a third component may be "connected," "coupled," and "joined" between the first and second components, although the first component may be directly connected, coupled, or joined to the second component. When it is stated that an element is "electrically coupled" to another element, the element may be "directly coupled" to the other element or "coupled" to the other element through a third element.

Reference to "A and/or B" throughout the specification means A, B, or A and B, unless specifically stated to the contrary. That is, "and/or" includes all or any combination of the plurality of listed items. Reference to "C to D" means that it is greater than or equal to C and less than or equal to D, unless specifically stated to the contrary.

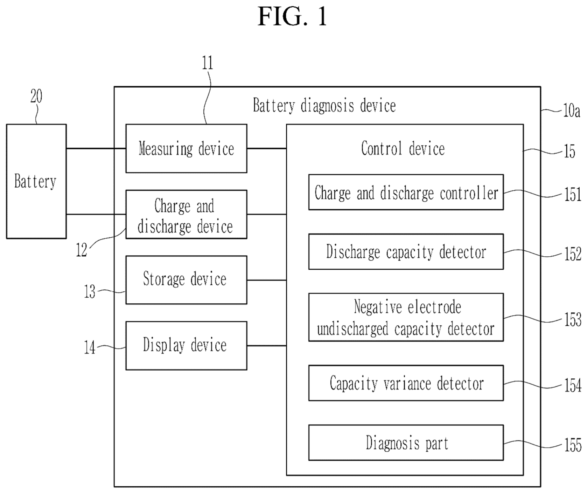

FIG. 1 depicts a block diagram of a battery diagnostic device according to an embodiment of the present disclosure.

Referring to FIG. 1, a battery diagnostic device 10a according to an embodiment is for diagnosing the formation status of a battery 20, and may include a measuring device 11, a charge and discharge device 12, a storage device 13, a display device 14, and a control device 15. The formation status may indicate whether the battery was properly prepared during manufacturing.

The measuring device 11 may measure the status values of the battery 20, such as voltage and current. In some embodiments, the measuring device 11 includes a sensor such as, for example, a voltage sensor and/or current sensor configured to sense, measure, or detect voltage and/or current of the battery. The battery 20 may include a rechargeable battery cell in a completed formation status, also referred to as a formed battery.

The charge and discharge device 12 may charge or discharge the battery 20 under the control of the control device 15. In some embodiments, the charge and discharge device may include a programmable power supply or battery cycler.

The storage device 13 may store various data, information, etc. processed in the battery diagnostic device 10a. The storage device 13 may store the status values (voltage values, current values, etc.) of the battery 20 measured through the measuring device 11. The storage device 13 may also store relationship data (hereinafter referred to as "reference data") indicating a correlation (e.g., a normal correlation or ideal correlation) between the initial capacity change amount of the battery 20 and the negative electrode undischarged capacity. Here, the normal correlation may refer to the correlation between the initial capacity change amount and the negative electrode undischarged capacity that appears when the battery 20 is a battery that satisfies a criterion (e.g., a normal battery cell that has normally completed formation).

In general, the internal structure of the battery 20 is optimized during the initial charge and discharge period that occurs after the completion of formation, and this may result in an initial capacity increase phenomenon in which the reversible capacity of the battery 20 increases during the initial charge and discharge period. In this specification, the initial charge and discharge period may refer to the period during which a predetermined number of cycles are performed on the battery 20 after (e.g., immediately after) the formation process is completed. Here, a cycle means the entire process of charging the battery 20 once and discharging it again (or the entire process of discharging the battery 20 once and charging it again), and may also be referred to as a charge and discharge cycle. Each cycle may include one charge period and one discharge period. For example, the charge section of each cycle performed during the initial charge and discharge period may mean the process of charging the battery from 0% to 100% status of charge (SOC), or the process of charging the battery from the discharge cut-off voltage to the charge cut-off voltage. In some embodiments, the discharge section of each cycle performed during the initial charge period may mean the process of discharging the battery from 100% to 0% SOC, or the process of discharging the battery from the charge cut-off voltage to the discharge cut-off voltage.

The initial capacity increase phenomenon may be caused by various factors such as electrode activation, solid electrolyte interphase (SEI) stabilization, electrolyte diffusion, and/or internal resistance reduction. The initial capacity increase during the initial charge and discharge period may be determined by the reversible capacity of the positive electrode which increases due to the activation of the positive electrode, and may also have a linear relationship with the negative electrode undischarged capacity. The negative electrode undischarged capacity may represent the capacity remaining inside the negative electrode without being discharged when the discharge of the battery 20 is completed. In some embodiments, the negative electrode undischarged capacity may correspond to the amount of lithium ions (Li) remaining inside the negative electrode when the battery 20 is discharged to the discharge cut-off voltage. Therefore, as the positive electrode reversible capacity of the battery 20 increases, the negative electrode undischarged capacity may decrease. The negative electrode undischarged capacity may also be represented as unused negative electrode capacity, residual lithium capacity, unactivated capacity, or unrecovered capacity.

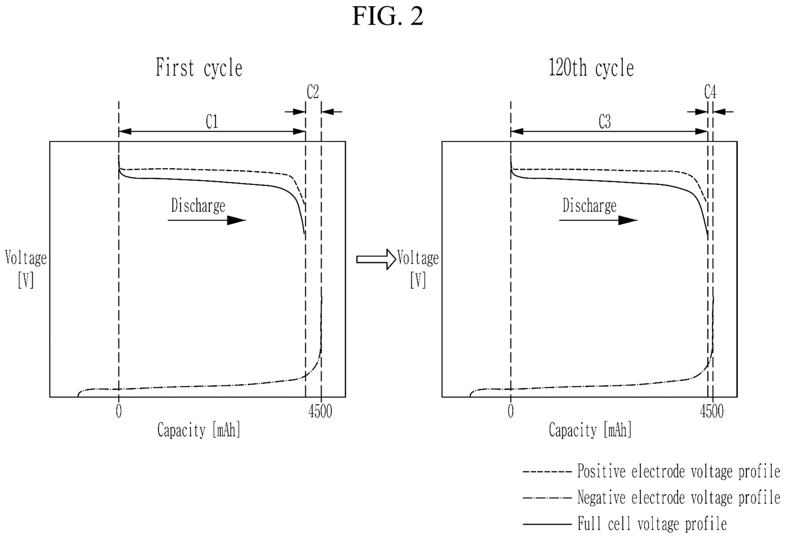

FIG. 2 depicts graphs of a positive electrode voltage profile, negative electrode voltage profile, and battery voltage profile, and a reversible capacity change of a battery during the initial charge and discharge period according to an embodiment of the present disclosure. In FIG. 2, the curves represent the positive electrode voltage profile, negative electrode voltage profile, and battery voltage profile of the battery during a corresponding discharge period. The positive electrode voltage profile is a curved representation of the relationship between the positive electrode voltage and capacity of the battery, and the negative electrode voltage profile is a curved representation of the relationship between the negative electrode voltage and capacity of the battery. In some embodiments, the battery voltage profile is a curved representation of the relationship between voltage and capacity of a full-cell battery.

Referring to FIG. 2, the battery immediately after formation is completed has an insufficiently activated positive electrode. Therefore, after the discharge section of a first cycle ends, there may be more undischarged negative electrode capacity (C2) inside the negative electrode than designed. Thereafter, as the cycle is repeated, the degree of activation of the positive electrode of the battery is gradually optimized, so that the reversible capacity of the positive electrode gradually increases, and thus the negative electrode undischarged capacity of the battery may gradually decrease closer to a designed value.

Taking FIG. 2 as an example, the negative electrode undischarged capacity (C4) remaining in the negative electrode of the battery after the discharge section in a 120th cycle is reduced compared to the negative electrode undischarged capacity (C2) remaining in the negative electrode of the battery after the discharge section in the first cycle. A gradual decrease in the negative electrode undischarged capacity of the battery may mean a gradual increase in the reversible capacity of the positive electrode. Therefore, a gradual decrease in the negative electrode undischarged capacity of the battery may mean a gradual increase in the reversible capacity of the battery. Taking FIG. 2 as an example, the battery capacity (C3) in the discharge section of the 120th cycle is increased compared to the battery capacity (C1) in the discharge section of the first cycle.

Thus, the initial capacity increase amount of a battery that has completed formation may be strongly correlated with the negative electrode undischarged capacity. In particular, the relationship between the initial capacity increase amount and the negative electrode undischarged capacity of batteries that have undergone the same formation process may be approximated by a linear equation.

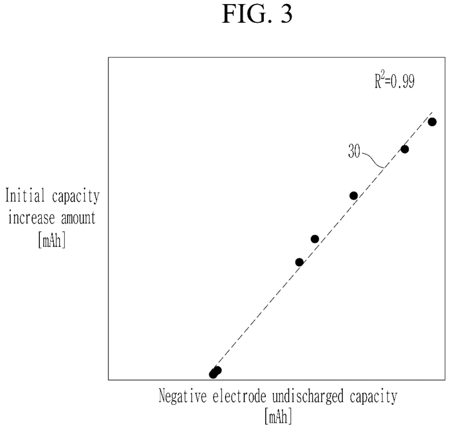

FIG. 3 depicts a graph of a relationship between the initial capacity increase amount of batteries and the negative electrode undischarged capacity as represented via a linear equation according to an embodiment of the present disclosure. In FIG. 3, the dots indicate the initial capacity increase amount according to the negative electrode undischarged capacity of a plurality of batteries that satisfy a criterion (e.g., that have normally completed formation). Referring to FIG. 3, the relationship between the initial capacity increase amount of the batteries and the negative electrode undischarged capacity may be approximated by a linear equation that may be represented by a trend line 30 in a linear shape.

Accordingly, in some embodiments, reference data representing correlation (e.g., an ideal correlation) between the initial capacity increase amount of the battery 20 and the negative electrode undischarged capacity (the correlation between the initial capacity change amount of the battery 20 and the negative electrode undischarged capacity expected when the battery 20 is a battery that satisfies a criterion (e.g., a normal quality battery that has completed the normal formation process)) is determined in advance, and the formation status of the battery 20 may be diagnosed by comparing the reference data with actual data of the battery 20 (actual initial capacity increase amount and actual negative electrode undischarged capacity).

The reference data may be determined in advance through simulation, experiment, etc. for a battery with the same or substantially the same specifications as the battery 20, and then stored in the storage device 13 during the manufacturing process of the battery diagnostic device 10a. The reference data may be stored in the storage device 13 of the battery diagnostic device 10a in the form of a linear equation or a lookup table. In the latter case, the lookup table may include a plurality of different initial capacity changes and a negative electrode undischarged capacity value corresponding to each initial capacity change.

Again, referring to FIG. 1, the display device 14 may display various information, data, etc. processed in the battery diagnostic device 10a.

The control device 15 may control the overall operation of the battery diagnostic device 10a. For example, the control device 15 may control the overall operation of the battery diagnostic device 10a based on computer instructions that are stored in memory.

The control device 15 may include a charge and discharge controller 151, a discharge capacity detector 152, a negative electrode undischarged capacity detector 153, a capacity variance detector 154, and a diagnosis part 155.

After the battery diagnostic device 10a enters the diagnostic mode, the charge and discharge controller 151 may control the charge and discharge device 12 so that a plurality of cycles are performed (e.g., continuously performed) for the battery 20. The charge and discharge controller 151 may control the charge and discharge device 12 so that among the plurality of cycles that are continuously performed, some of the cycles are charged and discharged at a low rate, and the remaining ones are charged and discharged at a high rate. In this description, "low rate" may refer to a low charge and discharge rate (C-rate) of 0.1C or less, and "high rate" may refer to a high charge and discharge rate (C-rate) of 0.3C or more. For example, the charge and discharge controller 151 may control the charge and discharge device 12 so that the battery 20 is charged and discharged at a low rate in one of a plurality of cycles (e.g., the first cycle), and the battery 20 is charged and discharged at a high rate in the subsequent plurality of cycles (e.g., second and third cycles).

The discharge capacity detector 152 may detect the discharge capacity in each cycle by using the status values (voltage, current, etc.) of the battery 20 measured while each cycle is in progress in the diagnostic mode. The discharge capacity detector 152 may determine the discharge capacity in each cycle using various methods such as a current integration method.

The negative electrode undischarged capacity detector 153 may determine the negative electrode undischarged capacity of the battery 20 by comparing the discharge capacity in two cycles with different charge and discharge rates among the plurality of cycles performed in the diagnostic mode.

In general, the positive electrode reversible capacity (hereinafter referred to as "positive electrode capacity") of the battery 20 may vary significantly depending on the charge and discharge rate (C-rate) of the battery 20. In some embodiments the negative electrode reversible capacity (hereinafter referred to as "negative electrode capacity") of the battery 20 shows almost no change according to the charge and discharge rate (C-rate). The positive electrode capacity of the battery 20 in a cycle that proceeds at a low rate may be very close to a theoretical value. Therefore, in a cycle that proceeds at a low rate, the negative electrode undischarged capacity of the battery 20 is hardly generated (or generated in a small amount), and the discharge capacity of the battery 20 may also be very close to the theoretical value. Here, the theoretical value of the positive electrode capacity may correspond to the maximum amount of lithium ions that may be used in the positive electrode of the battery 20, and the theoretical value of the discharge capacity may correspond to the maximum discharge capacity that the battery 20 may have.

In some embodiments, the positive electrode capacity of the battery 20 in a cycle that proceeds at a high rate may decrease compared to the theoretical value due to various reasons such as a limit on the diffusion rate of lithium ions, an increase in overvoltage, and an increase in internal resistance. Therefore, in a cycle that proceeds at a high rate, the negative electrode undischarged capacity of the battery 20 occurs, and the discharge capacity of the battery 20 may be reduced by the amount of the negative electrode undischarged capacity.

Accordingly, the negative electrode undischarged capacity detector 153 may determine the negative electrode undischarged capacity of the battery 20 by using the difference value between the discharge capacity in a cycle performed at a low rate (e.g., the first cycle) and the discharge capacity in a cycle performed at a high rate (e.g., the second cycle) in the diagnostic mode. The negative electrode undischarged capacity detected before the internal structure of the battery 20 is optimized (e.g., the negative electrode undischarged capacity detected in the initial charge and discharge period) may include an undischarged capacity component that occurs because the negative electrode or positive electrode is not sufficiently activated. If the battery 20 is in a defective formation status, the negative electrode undischarged capacity may also further include an undischarged capacity component due to the defective formation status of the battery 20.

If the negative electrode undischarged capacity of the battery 20 is determined, the negative electrode undischarged capacity detector 153 may store it in the storage device 13.

The capacity variance detector 154 may determine the battery capacity in each cycle performed in the diagnostic mode. The battery capacity in each cycle may correspond to the discharge capacity of the battery 20 in the discharge section of each cycle. The capacity variance detector 154 may determine the initial capacity change amount of the battery 20 by comparing the battery capacity in two cycles in which charge and discharge are performed at a high rate among the plurality of cycles. For example, the capacity variance detector 154 may determine the initial capacity increase amount of the battery 20 by using the value obtained by subtracting the battery capacity in the second cycle in which charging and discharging were performed at a high rate from the battery capacity in the third cycle in which charging and discharging were performed at a high rate.

If the initial capacity increase amount of the battery 20 is determined, the capacity change detector 154 may store data indicating the determined initial capacity increase amount in the storage device 13.

If diagnosis data (initial capacity change amount and negative electrode undischarged capacity) for diagnosing the formation status of the battery 20 is determined, the diagnosis part 155 may diagnose the formation status of the battery 20 by comparing the diagnosis data of the battery 20 with the reference data stored in the storage device 13.

The diagnosis part 155 may detect the amount or degree (error) by which the diagnosis data of the battery 20 deviates from the trend line corresponding to the reference data in a two-dimensional vector space using the initial capacity change amount and the negative electrode undischarged capacity as coordinate axes. If the error of the diagnosis data is greater than or equal to a threshold value, the diagnosis part 155 may determine that the battery 20 is in a defective formation status. In some embodiments, a battery that is determined to be in the defective formation status may be formatted again or displaced.

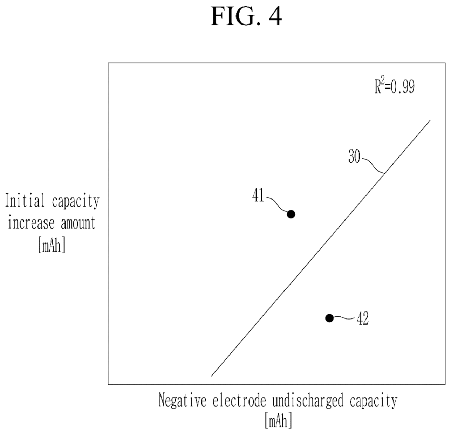

FIG. 4 depicts a graph of a trend line corresponding to the reference data according to an embodiment of the invention.

Referring to FIG. 4, diagnosis data 41 located above the trend line 30 may mean that the initial capacity increase amount of the corresponding battery is greater than in the normal case. An initial capacity increase amount larger than normal may mean that the positive electrode capacity activated in the corresponding battery during the initial charge and discharge period is larger than normal. Therefore, a battery with an initial capacity increase amount larger than normal may have completed the formation status where the positive electrode activation is insufficient due to insufficient impregnation at the positive electrode.

In some embodiments, diagnosis data 42 located below the trend line 30 may mean that the negative electrode undischarged capacity of the corresponding battery is greater than normal. A negative electrode undischarged capacity larger than normal may mean that the amount of lithium ions moving from the negative electrode to the positive electrode of the corresponding battery during the initial charge and discharge period is smaller than normal, and the amount of reversible lithium ions remaining in the negative electrode is larger. During the formation process, reversible lithium ions on the negative electrode surface are consumed, and if the film formation is insufficient due to insufficient impregnation, the consumption of reversible lithium ions during discharge may be small, and the amount of reversible lithium ions remaining on the negative electrode may increase. Therefore, a battery with a negative electrode undischarged capacity larger than normal may have completed the formation status where the negative electrode activation is insufficient due to insufficient impregnation at the negative electrode.

Again, referring to FIG. 1, the diagnosis part 155 may determine a reference initial capacity change amount corresponding to the negative electrode undischarged capacity of the battery 20 based on reference data. Then, if the difference between the actual initial capacity change amount of the battery 20 and the reference initial capacity change amount is greater than or equal to the threshold value, the battery 20 may be determined to be in a defective formation status. If the actual initial capacity change amount of the battery 20 is greater than the reference initial capacity change amount by a threshold value or more, the diagnosis part 155 may determine that the battery 20 is in a defective status where the formation process has been completed with insufficient activation of the positive electrode. If the actual initial capacity change amount of the battery 20 is less than the reference initial capacity change amount by a threshold value or more, the diagnosis part 155 may determine that the battery 20 is in a defective status where the formation process has been completed with insufficient activation of the negative electrode.

Based on the reference data, the diagnosis part 155 determines the reference negative electrode undischarged capacity corresponding to the initial capacity change amount of the battery 20, and may compare the actual negative electrode undischarged capacity of the battery 20 with the reference negative electrode undischarged capacity to diagnose the formation status of the battery 20. If the actual negative electrode undischarged capacity of the battery 20 is greater than the reference negative electrode undischarged capacity by a threshold value or more, the diagnosis part 155 may determine that the battery 20 is in a defective status where the formation process has been completed with insufficient activation of the negative electrode. If the actual negative electrode undischarged capacity of the battery 20 is less than the reference negative electrode undischarged capacity by a threshold value or more, the diagnosis part 155 may determine that the battery 20 is in a defective status where the formation process has been completed with insufficient activation of the positive electrode.

After the diagnosis is completed, the diagnosis part 155 may display a diagnosis result on the screen of the display device 14. The diagnosis part 155 may display different diagnosis results depending on whether the battery 20 can undergo the formation process again (e.g., is reformable). If the battery 20 is determined to be in a defective formation status after passing a first (e.g., only one) formation process, the diagnosis part 155 may output guide information recommending reformation of the battery 20 together with information indicating the defective formation status of the battery 20 on the display device 14. The control device 15 may invoke a second formation of the battery 20 based on the output recommendation. If the battery 20 is determined to be a reformed battery that has passed through a second number (e.g., two or more) of formation processes and is in a defective formation status, the diagnosis part 155 may output guide information recommending disposal of the battery 20 together with information indicating the defective formation status of the battery 20 on the display device 14. The battery may be removed from a production line and disposed based on the output recommendation.

The diagnosis part 155 may also transmit the diagnosis result to an external device (e.g., an administrator terminal or an upper controller) via wired or wireless communication.

In some embodiments, the above embodiment illustrates a case where reference data is determined in advance through experiments, simulations, etc. and then stored in the storage device 13 during the manufacturing process of the battery diagnostic device 10a. However, in some embodiments, the battery diagnostic device may generate or update the baseline data using data actually collected from a plurality of batteries that have completed formation (initial capacity increase amount and negative electrode undischarged capacity).

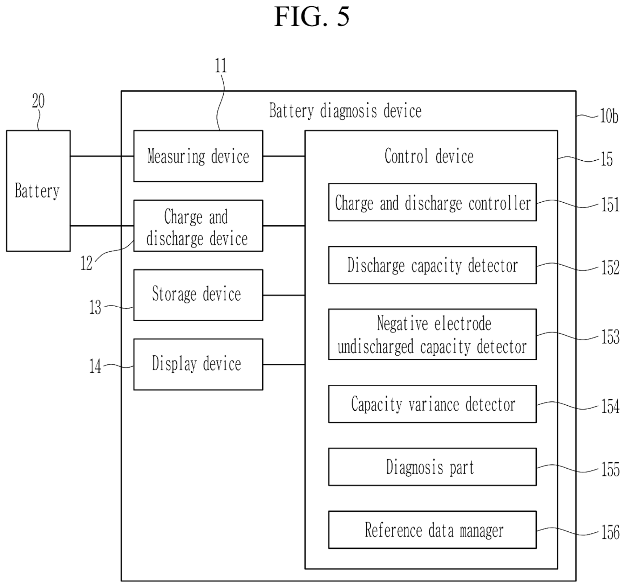

FIG. 5 depicts another block diagram of a battery diagnostic device 10b according to an embodiment of the present disclosure. Referring to FIG. 5, the control device 15 of the battery diagnostic device 10b according to an embodiment may further include a reference data manager 156 as opposed to the battery diagnostic device 10a of FIG. 1. In order to avoid redundant descriptions below, detailed descriptions of components of the battery diagnostic device 10b that overlap with those of the battery diagnostic device 10a of FIG. 1 may be omitted.

The negative electrode undischarged capacity detector 153 may determine the negative electrode undischarged capacity for the plurality of batteries that satisfy a criterion (e.g., have normally completed formation in the above-described manner), and may store data indicating the negative electrode undischarged capacity of each battery in the storage device 13.

The capacity variance detector 154 may determine the initial capacity change amount for the plurality of batteries that satisfy the criterion (e.g., have completed normal formation) in the above-described manner, and may store data indicating the initial capacity change amount of each battery in the storage device 13.

The reference data manager 156 may derive a linear equation representing the relationship between the initial capacity change amount of the batteries and the negative electrode undischarged capacity through linear regression analysis of the initial capacity change amount of the batteries detected through the negative electrode undischarged capacity detector 153 and the initial capacity change amount detected through the capacity variance detector 154. Then, the reference data manager 156 may generate reference data using the derived linear equation.

The reference data manager 156 may update the reference data by additionally reflecting the initial capacity change amount and negative electrode undischarged capacity of the batteries that were the targets of the diagnosis whenever the formation status diagnosis is completed for a set number of batteries.

The reference data manager 156 may perform filtering, such as outlier detection, on data collected from batteries (e.g., the initial capacity change amount and negative electrode undischarged capacity) to improve the accuracy of reference data when generating or updating reference data, and may also generate or update reference data using the filtered data.

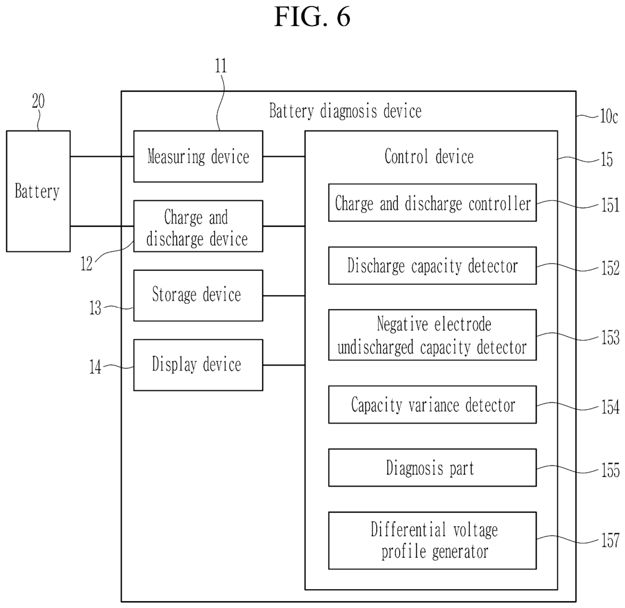

FIG. 6 depicts another block diagram of a battery diagnostic device according to an embodiment of the present disclosure.

Referring to FIG. 6, the control device 15 of a battery diagnostic device 10c according to an embodiment may further include a differential voltage profile generator 157 as opposed to the battery diagnostic device 10a of FIG. 1. In order to avoid redundant descriptions below, detailed descriptions of components of the battery diagnostic device 10c that overlap with those of the battery diagnostic device 10a of FIG. 1 may be omitted.

The storage device 13 may additionally store voltage profiles, differential voltage profiles, etc. generated by the control device 15. In some embodiments, the voltage profile may be data for diagramming the relationship between the voltage and capacity of the battery 20 during the cycle in the form of a curve. In some embodiments, the differential voltage profile may be data for diagramming the relationship between the voltage change rate (or differential voltage (dV/dQ)) and capacity of the battery 20 during the cycle in the form of a curve. Capacity in the voltage profile and differential voltage profile may mean the total amount of charge moved by charging or discharging the battery 20 (e.g., the charge capacity or discharge capacity). The voltage profile may be stored in the storage device 13 in the form of a lookup table including voltage values of the battery 20 and capacity values corresponding to each voltage value. The differential voltage profile may be stored in the storage device 13 in the form of a lookup table including differential voltage values of the battery 20 and a capacity value corresponding to each differential voltage value.

After the battery diagnostic device 10c enters the diagnosis mode, the charge and discharge controller 151 may control the charge and discharge device 12 so that the plurality of cycles are performed (e.g., performed continuously) for the battery 20. The charge and discharge controller 151 may control the charge and discharge device 12 to perform low-rate charge and high-rate discharge during some of the continuously performed cycles (e.g., the first cycle), and control the charge and discharge device 12 to perform charge and discharge at a high rate during the remaining cycles (e.g., the second and third cycles).

The differential voltage profile generator 157 may generate the voltage profile of the battery 20 in each cycle by using the status values (voltage, current, etc.) of the battery 20 measured while each cycle is in progress in the diagnosis mode. In some embodiments, the differential voltage profile generator 157 may differentiate the voltage profile in each cycle to generate a differential voltage profile in each cycle. The differential voltage profile generator 157 may store the generated voltage profile and differential voltage profile in the storage device 13.

The negative electrode undischarged capacity detector 153 may determine the negative electrode undischarged capacity of the battery 20 using the differential voltage profile in one cycle performed in the diagnosis mode.

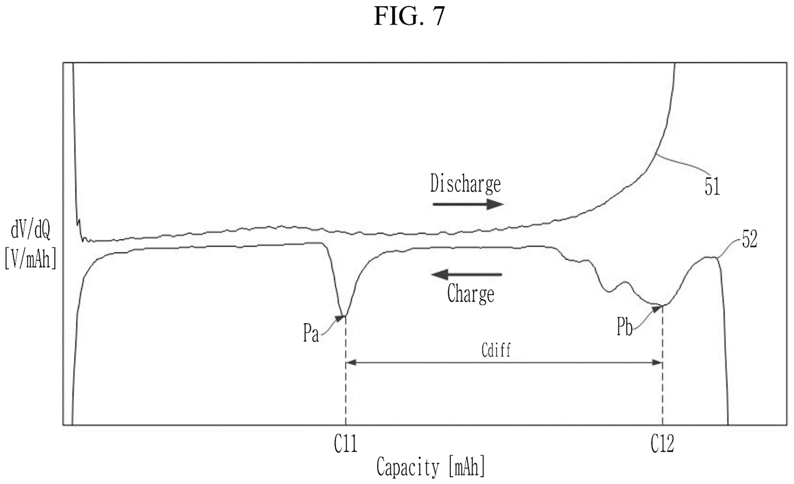

FIG. 7 depicts a graph of a differential voltage profile in a cycle in which charge is performed at a first (e.g., low) rate in the charge section and discharge is performed at a second (e.g., high or higher) rate in the discharge section according to an embodiment of the present disclosure. Referring to FIG. 7, the differential voltage profile may include a differential voltage curve 51 in the discharge section and a differential voltage curve 52 in the charge section. The differential voltage curve 52 in the charge section may include two negative electrode-induced peaks Pa and Pb caused by lithium insertion in the negative electrode. A distance Cdiff between the negative electrode peaks Pa and Pb on the capacity coordinate axis may be strongly correlated with the negative electrode capacity of the battery (e.g., the reversible capacity of the negative electrode).

In some embodiments, the negative electrode undischarged capacity detector 153 may detect two negative electrode-induced peaks Pa and Pb from the differential voltage curve 52 of the charge section, and determine the negative electrode capacity of the battery 20 based on the distance Cdiff between the detected negative electrode-induced peaks Pa and Pb. The negative electrode undischarged capacity detector 153 may detect the capacity coordinate values of each negative electrode-induced peak Pa and Pb in the differential voltage profile, and may determine the distance Cdiff between the negative electrode-induced peaks Pa and Pb using the difference value between the capacity coordinate values of the negative electrode-induced peaks Pa and Pb. If the distance Cdiff between the negative electrode-induced peaks Pa and Pb is determined, the negative electrode discharged capacity detector 153 may determine the negative electrode capacity of the battery 20 from the distance Cdiff between the negative electrode-induced peaks Pa and Pb using a predefined or identified relationship equation. In some embodiments, the relationship equation is a linear equation, which may be determined in advance through simulation, experiment, etc., and then stored in the storage device 13 during the manufacturing step of the battery diagnostic device 10c.

After the negative electrode capacity of the battery 20 is determined, the negative electrode undischarged capacity detector 153 may determine the negative electrode undischarged capacity of the battery 20 using the difference value between the discharge capacity of the battery 20 and the negative electrode capacity in the corresponding cycle.

If the negative electrode undischarged capacity of the battery 20 is determined, the negative electrode undischarged capacity detector 153 may store data indicating this in the storage device 13.

The capacity variance detector 154 may determine the battery capacity in each cycle performed in the diagnosis mode. The capacity variance detector 154 may determine the initial capacity change amount of the battery 20 by comparing the battery capacity (e.g., discharge capacity) in two cycles in which charging and discharging are performed at a high rate among the plurality of cycles. For example, the capacity variance detector 154 may determine the initial capacity increase amount of the battery 20 by using the value obtained by subtracting the battery capacity in the second cycle in which charging and discharging were performed at a high rate from the battery capacity in the third cycle in which charging and discharging were performed at a high rate.

If the initial capacity increase amount of the battery 20 is determined, the capacity change detector 154 may store data indicating the initial capacity increase amount of the battery 20 in the storage device 13.

If diagnosis data (initial capacity change amount and negative electrode undischarged capacity) of the battery 20 are determined, the diagnosis part 155 may diagnose the formation status of the battery 20 by comparing the diagnosis data of the battery 20 with the reference data stored in the storage device 13. After the diagnosis is completed, the diagnosis part 155 may display the diagnosis result on the screen through the display device 14 or transmit the diagnosis result to an external device (e.g., an administrator terminal or an upper controller) through wired or wireless communication.

In the above-described embodiments, the control device 15 may include at least one processor for performing at least one of the functions of the charge and discharge controller 151, the discharge capacity detector 152, the negative electrode undischarged capacity detector 153, the capacity variance detector 154, the diagnosis part 155, the reference data manager 156, and the differential voltage profile generator 157. The processor may refer to a data processing device that is physically structured with circuits to perform functions represented by code or instructions included in a program, such as a microprocessor, a central processing unit (CPU), a processor core, a multiprocessor, an application-specific integrated circuit (ASIC), and a field programmable gate array (FPGA).

In some embodiments, in the embodiments described above, the storage device 13 may store a program for the operations of the control device 15. In some embodiments, the storage device 13 may include at least one memory. Memory is a readable recording medium in a computing device, and may include various types of volatile or non-volatile recording media. The memory may include various types of recording media, such as flash memory type, hard disk type, card type (e.g., SD or XD memory), random access memory (RAM), static random access memory (SRAM), read-only memory (ROM), electrically erasable programmable read-only memory (EEPROM), and programmable read-only memory (PROM).

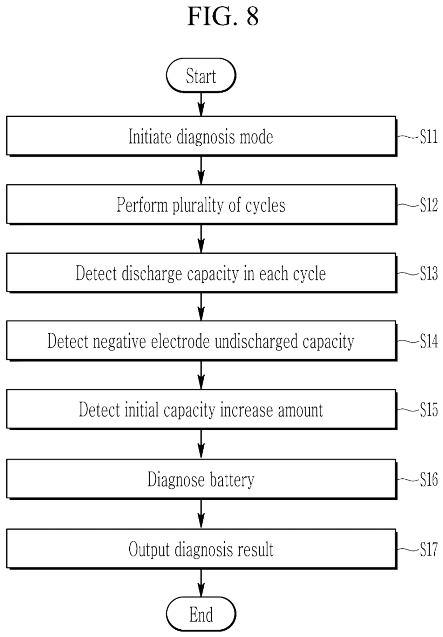

FIG. 8 depicts a flow diagram of a battery diagnostic method according to an embodiment of the present disclosure. The method of FIG. 8 may be performed by the control device 15 of the battery diagnostic devices 10a and 10b described with reference to FIG. 1 and FIG. 5.

Referring to FIG. 8, upon initiation of the diagnosis mode (S11), the control device 15 may control the charge and discharge device 12 to sequentially perform the plurality of cycles for the battery 20 that is the diagnosis target (S12). In step S12, the control device 15 may control the charge and discharge device 12 so that among the plurality of cycles that are continuously performed, some of the cycles are charged and discharged at a low rate, and the remaining ones are charged and discharged at a high rate. For example, the control device 15 may control the charge and discharge device 12 so that the battery 20 is charged and discharged at a low rate in the first cycle, and then the battery 20 is charged and discharged at a high rate in the second and third cycles performed thereafter.

The control device 15 may detect the discharge capacity in each cycle by using the status values (e.g., voltage, current, etc.) of the battery 20 measured while each cycle is in progress in the diagnosis mode (S13). In step S13, the control device 15 may determine the discharge capacity in each cycle using various methods such as the current integration method.

The control device 15 may determine the negative electrode undischarged capacity of the battery 20 by comparing the discharge capacity in two cycles with different charge and discharge rates among the plurality of cycles performed in the diagnosis mode (S14). In step S14, the control device 15 may determine the negative electrode undischarged capacity of the battery 20 by using the difference value between the discharge capacity in a cycle performed at a low rate (e.g., the first cycle) and the discharge capacity in a cycle performed at a high rate (e.g., the second cycle).

The control device 15 may detect the initial capacity increase amount of the battery 20 based on the battery capacity in each cycle performed in the diagnosis mode (S15). In step S15, the control device 15 may determine the discharge capacity in each cycle as the battery capacity in each cycle. In step S15, the control device 15 may determine the initial capacity change amount of the battery 20 by comparing the battery capacity in two cycles in which charging and discharging are performed at a high rate among the plurality of cycles. For example, the control device 15 may determine the initial capacity increase amount of the battery 20 by using the value obtained by subtracting the battery capacity in the second cycle in which charging and discharging were performed at a high rate from the battery capacity in the third cycle in which charging and discharging were performed at a high rate.

The control device 15 may diagnose the formation status of the battery 20 by comparing the data (e.g., the initial capacity change amount and negative electrode undischarged capacity) detected through steps S14 and S15 with previously stored reference data (S16). The reference data may be data indicating the correlation between the initial capacity change amount of the battery 20 and the negative electrode undischarged capacity expected when the battery 20 is a battery that satisfies a criterion (e.g., a normal quality battery that has completed the formation process normally).

In step S16, the control device 15 may diagnose the formation status of the battery 20 by checking the extent to which the diagnosis data (initial capacity change amount and negative electrode undischarged capacity) of the battery 20 deviates from the trend line corresponding to the reference data on a two-dimensional vector space using the initial capacity change amount and the negative electrode undischarged capacity as coordinate axes. In step S16, the control device 15 determines a reference initial capacity change amount corresponding to the negative electrode undischarged capacity of the battery 20 based on the reference data, and may diagnose the formation status of the battery 20 by comparing the actual initial capacity change amount of the battery 20 with the reference initial capacity change amount. In step S16, the control device 15 determines the reference negative electrode undischarged capacity corresponding to the initial capacity change amount of the battery 20, and may compare the actual negative electrode undischarged capacity of the battery 20 with the reference negative electrode undischarged capacity to diagnose the formation status of the battery 20.

After the diagnosis of the formation status of the battery 20 is completed, the control device 15 may output the diagnosis result to the display device 14 or an external device (not shown) (S17). In step S17, the control device 15 may display different diagnosis results depending on whether the battery 20 is reformable. If the battery 20 is determined to be in a defective formation status after passing only one formation process, the control device 15 may output guide information recommending the reformation of the battery 20 together with information indicating the defective formation status of the battery 20. The battery may be formed again based on the information. If the battery 20 is determined to be a reformed battery that has passed through two or more formation processes and is in a defective formation status, the control device 15 may output guide information recommending disposal of the battery 20 together with information indicating the defective formation status of the battery 20. The battery may be disposed based on the information.

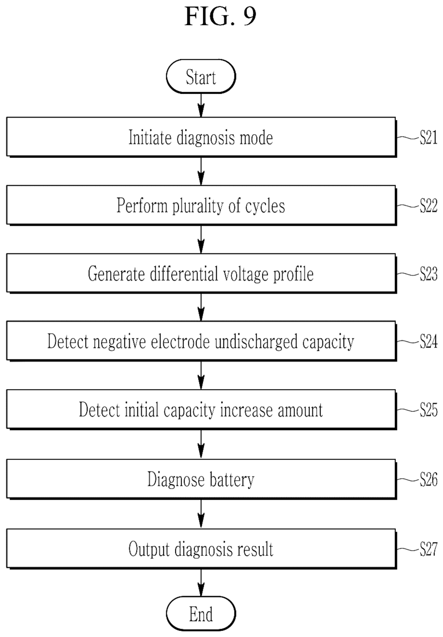

FIG. 9 depicts another flow diagram of a battery diagnostic method according to an embodiment of the present disclosure. The method of FIG. 9 may be performed by the control device 15 of the battery diagnostic device 10c described with reference to FIG. 6. Below, to avoid redundant descriptions, detailed descriptions of steps of the battery diagnostic method of FIG. 9 that overlap with the battery diagnostic method of FIG. 8 may be omitted.

Referring to FIG. 9, upon initiation of the diagnosis mode (S21), the control device 15 may control the charge and discharge device 12 to sequentially perform the plurality of cycles for the battery 20 that is the diagnosis target (S22). In step S22, the control device 15 may control the charge and discharge device 12 to perform low-rate charge and high-rate discharge during some of the continuously performed cycles (e.g., the first cycle), and control the charge and discharge device 12 to perform charge and discharge at a high rate during the remaining cycles (e.g., the second and third cycles).

The control device 15 may generate the differential voltage profile in each cycle by using the status values (voltage, current, etc.) of the battery 20 measured while each cycle is in progress in the diagnosis mode (S23). In step S23, the control device 15 may generate the voltage profile of the battery 20 in each cycle by using the status values (voltage, current, etc.) of the battery 20 measured while each cycle is in progress. In some embodiments, the control device 15 may differentiate the voltage profile in each cycle to generate a differential voltage profile in each cycle.

The control device 15 may detect the negative electrode undischarged capacity of the battery 20 using the differential voltage profile (S24). In step S24, the control device 15 may detect two negative electrode-induced peaks from the differential voltage curve of the cycle that proceeded with low-rate charge and high-rate discharge, and may detect the distance between these two negative electrode-induced peaks on the capacity coordinate axis of the differential voltage curve. After the distance between the negative electrode-induced peaks is determined, the control device 15 may determine the negative electrode capacity of the battery 20 from the distance between the negative electrode-induced peaks using a predefined relationship equation. After the negative electrode capacity of the battery 20 is determined, the control device 15 may determine the negative electrode undischarged capacity of the battery 20 using the difference value between the discharge capacity of the battery 20 and the negative electrode capacity in the corresponding cycle.

The control device 15 may detect the initial capacity increase amount of the battery 20 based on the battery capacity in each cycle performed in the diagnosis mode (S25). In step S25, the control device 15 may determine the initial capacity change amount of the battery 20 by comparing the battery capacity in two cycles in which charge and discharge are performed at a high rate among the plurality of cycles. For example, the control device 15 may determine the initial capacity increase amount of the battery 20 by using the value obtained by subtracting the battery capacity in the second cycle in which charging and discharging were performed at a high rate from the battery capacity in the third cycle in which charging and discharging were performed at a high rate.

The control device 15 may diagnose the formation status of the battery 20 by comparing the data (initial capacity change amount and negative electrode undischarged capacity) detected through steps S24 and S25 with previously stored reference data (S26). After the diagnosis of the formation status of the battery 20 is completed, the control device 15 may output the diagnosis result to the display device 14 or an external device (not shown) (S27).

The formation quality of a battery (e.g., whether the battery has been reliably activated) is one of the factors determining long-term life span characteristics of the battery. If the formation state of the battery is not normal, the long-term life span characteristics of the battery may be degraded. Therefore, a method is needed to diagnose the formation quality of a battery that has completed formation. The above-described embodiments may provide a method for diagnosing the formation status of a battery that has completed formation in real time.

While the embodiments of the present disclosure have been described in detail, it is to be understood that the disclosure is not limited to the disclosed embodiments, but on the contrary, is intended to cover various modifications and equivalent arrangements included within the scope of the appended claims.

### Description of symbols

10a, 10b, 10c: Battery diagnostic device
11: Measuring device
12: Charge and discharge device
13: Storage device
14: Display device
15: Control device
20: Battery
151: Charge and discharge controller
152: Discharge capacity detector
153: Negative electrode undischarged capacity detector
154: Capacity variance detector
155: Diagnosis part
156: Reference data manager
157: Differential voltage profile generator

## Claims

1. A battery diagnostic device, comprising:
a measuring device configured to measure status values of a formed battery;
a charge and discharge device configured to charge and discharge the formed battery over a plurality of cycles; and
a control device configured to detect a discharge capacity in each cycle of the plurality of cycles based on the status values measured in each cycle, detect an initial capacity increase amount of the formed battery based on a difference in discharge capacity between two cycles among the plurality of cycles, detect a negative electrode undischarged capacity of the formed battery based on the discharge capacity in at least one cycle among the plurality of cycles, and diagnose a formation status of the formed battery based on the initial capacity increase amount and the negative electrode undischarged capacity and output a diagnosis result,
wherein, based on the diagnosis result, the control device is configured to invoke a second formation of the formed battery.

2. The battery diagnostic device as claimed in claim 1, wherein
the charge and discharge rate in the two cycles is 0.3C or more.

3. The battery diagnostic device as claimed in claim 1 or claim 2, wherein the control device is further configured to:
detect the discharge capacity of the formed battery and a negative electrode capacity of the formed battery in a first cycle using the status values measured during the first cycle among the plurality of cycles; and
determine the negative electrode undischarged capacity from the difference between the discharge capacity of the formed battery and the negative electrode capacity in the first cycle;
optionally:
(i) wherein
the control device is further configured to:
generate a differential voltage profile corresponding to the first cycle using the status values measured during the first cycle; and
detect the negative electrode capacity using the differential voltage profile; and/or
(ii) wherein:
a charge rate in a charge section of the first cycle is 0.1C or less; and
a discharge rate in a discharge section of the first cycle is 0.3C or more.

4. The battery diagnostic device as claimed in claim 1, wherein:
the control device is further configured to:
detect the discharge capacity of the formed battery in a first cycle and a second cycle among the plurality of cycles based on the status values; and
detect the negative electrode undischarged capacity using the difference in the discharge capacity between the first cycle and the second cycle,
wherein, a charge and discharge rate in the first cycle is 0.1C or less, and a charge and discharge rate in the second cycle is 0.3C or higher.

5. The battery diagnostic device as claimed in any preceding claim, further comprising:
a storage device configured to store reference data,
wherein the control device is further configured to diagnose the formation status of the formed battery by comparing the initial capacity increase amount and the negative electrode undischarged capacity with the reference data, and
wherein the reference data represents a correlation between a second initial capacity increase amount of a second battery and a second negative electrode undischarged capacity.

6. The battery diagnostic device as claimed in claim 5, wherein
the control device is further configured to:
detect the second initial capacity increase amount and the second negative electrode undischarged capacity from a plurality of batteries; and
generate the reference data using the second initial capacity increase amount of the plurality of batteries and the second negative electrode undischarged capacity.

7. The battery diagnostic device as claimed in claim 5 or claim 6, wherein the control device is further configured to:
determine a reference negative electrode undischarged capacity corresponding to the initial capacity increase amount of the formed battery using the reference data; and
diagnose the formation status of the formed battery by comparing the negative electrode undischarged capacity of the formed battery with the reference negative electrode undischarged capacity.

8. The battery diagnostic device as claimed in claim 5 or claim 6, wherein the control device is further configured to:
determine a reference initial capacity increase amount corresponding to the negative electrode undischarged capacity of the formed battery using the reference data; and
diagnose the formation status of the formed battery by comparing the initial capacity increase amount of the formed battery with the reference initial capacity increase amount.

9. A battery diagnostic method of at least one processor, comprising:
charging and discharging a formed battery that has completed formation over a plurality of cycles;
detecting a discharge capacity of the formed battery in each cycle based on status values of the formed battery measured in each cycle of the plurality of cycles;
detecting an initial capacity increase amount of the formed battery based on a difference in discharge capacity between two cycles among the plurality of cycles;
detecting a negative electrode undischarged capacity of the formed battery based on the discharge capacity in at least one cycle among the plurality of cycles;
diagnosing a formation status of the formed battery based on the initial capacity increase amount and the negative electrode undischarged capacity and outputting a diagnosis result; and
performing a second formation of the formed battery based on the output,
optionally wherein a charge and discharge rate in the two cycles is 0.3C or more.

10. The battery diagnostic method as claimed in claim 9, wherein
the detecting of the negative electrode undischarged capacity comprises:
determining the negative electrode undischarged capacity from the difference between the discharge capacity of the formed battery in a first cycle among the plurality of cycles and a negative electrode capacity of the formed battery,
optionally:
(i) wherein:
the detecting of the negative electrode undischarged capacity further comprises:
generating a differential voltage profile corresponding to the first cycle using the status values measured during the first cycle;
detecting a plurality of negative electrode-induced peaks in the differential voltage profile; and
determining the negative electrode capacity based on positions of the plurality of negative electrode-induced peaks; and/or
(ii) wherein:
a charge rate in a charge section of the first cycle is 0.1C or less; and
a discharge rate in a discharge section of the first cycle is 0.3C or more.

11. The battery diagnostic method as claimed in claim 9, wherein:
the detecting of the negative electrode undischarged capacity further comprises determining the negative electrode undischarged capacity based on a difference in discharge capacity between a first cycle and a second cycle among the plurality of cycles;
a charge and discharge rate in the first cycle is 0.1C or less; and
a charge and discharge rate in the second cycle is 0.3C or higher.

12. The battery diagnostic method as claimed in any of claims 9-11, wherein:
the diagnosing comprises diagnosing the formation status of the formed battery by comparing the initial capacity increase amount and the negative electrode undischarged capacity with reference data, and
the reference data represents a correlation between a second initial capacity increase amount of a second battery and a second negative electrode undischarged capacity.

13. The battery diagnostic method as claimed in claim 12, further comprising:
detecting the second initial capacity increase amount and the second negative electrode undischarged capacity from a plurality of batteries; and
generating the reference data using the second initial capacity increase amount of the plurality of batteries and the second negative electrode undischarged capacity.

14. The battery diagnostic method as claimed in claim 12 or claim 13, wherein
the diagnosing of the formation status of the formed battery by comparing the initial capacity increase amount and the negative electrode undischarged capacity with the reference data comprises:
determining a reference negative electrode undischarged capacity corresponding to the initial capacity increase amount of the formed battery using the reference data; and
diagnosing the formation status of the formed battery by comparing the negative electrode undischarged capacity of the formed battery with the reference negative electrode undischarged capacity.

15. The battery diagnostic method as claimed in claim 12 or claim 13, wherein
the diagnosing of the formation status of the formed battery by comparing the initial capacity increase amount and the negative electrode undischarged capacity with the reference data comprises:
determining a reference initial capacity increase amount corresponding to the negative electrode undischarged capacity of the formed battery using the reference data; and
diagnosing the formation status of the formed battery by comparing the initial capacity increase amount of the formed battery with the reference initial capacity increase amount.
